# EUROPÄISCHE PATENTSCHRIFT

(11) **EP 0 787 822 B1**
(45) Veröffentlichungstag und Bekanntmachung des Hinweises auf die Patenterteilung: **28.03.2001**
(21) Anmeldenummer: 97100682.0
(22) Anmeldetag: 17.01.1997
(51) Int. Cl.: C23C 16/32, C23C 16/44

(54) **Verfahren zum Herstellen von SiC durch CVD mit verbesserter Gasausnutzung**
Process for producing SiC by CVD with improved gas consumption
Procédé de fabrication de SiC par CVD avec une consommation de gaz améliorée

(30) Priorität: 30.01.1996 DE 19603323
(43) Veröffentlichungstag der Anmeldung: 06.08.1997
(73) Patentinhaber: SIEMENS AKTIENGESELLSCHAFT, 80333 München (DE)
(72) Erfinder: Rupp, Roland, Dr., 91207 Lauf (DE); Völkl, Johannes, Dr., 91056 Erlangen (DE)
(74) Vertreter: Epping, Wilhelm, Dipl.-Ing.

(56) Entgegenhaltungen:
- EP-A- 0 582 444
- DE-A- 4 142 877
- US-A- 4 340 568
- PATENT ABSTRACTS OF JAPAN vol. 013, no. 011 (C-558), 11.Januar 1989 & JP 63 216973 A (HITACHI ELECTRONICS ENG CO LTD), 9.September 1988,

## Beschreibung

Die Erfindung betrifft ein Verfahren zum Herstellen von Siliciumcarbid durch chemisches Abscheiden aus der Gasphase (CVD).

Bei einem CVD-Prozeß zum Herstellen von Silciumcarbid (SiC) wird ein Gasstrom aus Arbeitsgasen zum Zuführen von Silicium und Kohlenstoff und einem Trägergas (im allgemeinen Wasserstoff) auf ein Substrat geleitet und aus dem Gasgemisch durch chemische Reaktionen SiC auf dem Substrat abgeschieden. Aus *"Technical Digest of International Conference on SiC and Related Materials, Kyoto, Japan, 1995, Seite 609"* ist ein CVD-Verfahren zum Herstellen von einkristallinem SiC bekannt, bei dem die Substrattemperaturen zwischen 1800°C und 2300°C eingestellt werden. Man erreicht dadurch hohe Wachstumsraten, ohne die Kristallqualität negativ zu beeinflussen. Die Wachstumsraten bei diesem bekannten Verfahren betragen bis zu 0,5 mm/h. Allerdings können mit dem bekannten Verfahren nur Kristalle einer Länge von maximal 2 mm gezüchtet werden.

Der Erfindung liegt nun die Aufgabe zugrunde, ein Verfahren zum Herstellen von Siliciumcarbid durch CVD anzugeben, bei dem eine größere Ausnutzung der Prozeßgase als beim Stand der Technik erreicht wird.

Diese Aufgabe wird gemäß der Erfindung gelöst durch die Merkmale des Anspruchs 1.

Beim Verfahren gemäß Anspruch 1 zum Herstellen von Siliciumcarbid wird ein erster Gasstrom mit wenigstens einem Arbeitsgas zum Zuführen von Silicium (Si) und Kohlenstoff (C) und mit wenigstens einem Trägergas auf ein Substrat gerichtet. Aus diesem ersten Gasstrom wächst auf dem Substrat durch chemische Gasphasenabscheidung (CVD) Siliciumcarbid auf. Es wird ferner ein Gasstrom erzeugt, der den ersten Gasstrom parallel zu dessen Strömungsrichtung vollständig umschließt und der in den abscheidevorgang am Substrat chemisch nicht eingreift. Außerdem wird eine Strömungsgeschwindigkeit des ersten Gasstromes zwischen 10 m/min und 300 m/min eingestellt.

Eine zur Durchführung des Verfahrens geeignete Vorrichtung umfaßt dann einen Reaktor, wenigstens ein in dem Reaktor angeordnetes Substrat, Mittel zum Erzeugen eines auf das Substrat gerichteten ersten Gasstromes mit einer Strömungsgeschwindigkeit zwischen 10 m/min und 300 m/min, wobei der erste Gasstrom wenigstens ein Arbeitsgas zum Zuführen von Silicium (Si) und Kohlenstoff (C)und wenigstens ein Trägergas enthält, und aus dem ersten Gasstrom durch chemische Gasphasenabscheidung Siliciumcarbid auf dem Substrat aufwächst, und Mittel zum Erzeugen eines zweiten Gasstromes, der den ersten Gasstrom parallel zu dessen Strömungsrichtung vollständig einschließt und der in den Abscheidevorgang am Substrat chemisch nicht eingreift.

Die Erfindung beruht auf der Erkenntnis, daß durch den den ersten Gasstrom umgebenden, zweiten Gasstrom die Divergenz des ersten Gasstromes reduziert werden kann und somit eine hohe Stabilität der Konzentration der Prozeßgase in dem ersten Gasstrom erreicht wird. Dadurch erhält man eine größere Ausnutzung der in den Prozeß eingebrachten Arbeitsgase. Bei gleichen Wachstumstemperaturen am Substrat und gleichen Gesamtgasflüssen der Prozeßgase erhöht sich somit die Wachstumsrate des aufwachsenden Siliciumcarbids. Mit dem zweiten Gasstrom gemäß der Erfindung konnte eine mehr als zehnmal höhere Arbeitsgasausbeute erzielt werden als ohne den zweiten Gasstrom.

Vorteilhafte Ausgestaltungen und Weiterbildungen des Verfahrens ergeben sich aus den vom Anspruch 1 jeweils abhängigen Ansprüchen. In einer ersten vorteilhaften Ausführungsform wird durch eine entsprechende Ausbildung der Mittel zum Erzeugen der beiden Gasströme die Strömungsgeschwindigkeit des ersten Gasstromes größer eingestellt als die Strömungsgeschwindigkeit des zweiten Gasstromes. Durch die höhere Strömungsgeschwindigkeit des ersten Gasstromes wird der Verlust an Prozeßgasen durch Interdiffusion von Gaspartikeln der Prozeßgase und des wenigstens einen Trägergases vom ersten Gasstrom in den zweiten Gasstrom klein gehalten.

Die Mittel zum Erzeugen des auf das Substrat gerichteten, ersten Gasstromes enthalten vorzugsweise wenigstens eine Düse mit einer dem Substrat zugewandten Auslaßöffnung und Mittel zum Zuführen des wenigstens einen Arbeitsgases und des wenigstens einen Trägergases zur Düse. Die Mittel zum Erzeugen des zweiten Gasstromes können dann einen Diffusor erhalten, der einen weitgehend homogenen zweiten Gasstrom erzeugt und die Düse der Mittel zum Erzeugen des ersten Gasstromes umgibt.

In einer weiteren Ausführungsform wird für den zweiten Gasstrom ein Gas oder Gasgemisch mit einer geringeren Viskosität als der erste Gasstrom vorgesehen. Dadurch wird eine Vermischung der beiden Gasströme infolge von Verwirbelungen vermieden.

Bevorzugte Gase für den zweiten Gasstrom sind Gase, die Graphit chemisch nicht angreifen, insbesondere Edelgase oder Edelgasgemische. Es können dann auch bei hohen Temperaturen im Reaktor Graphitteile verwendet werden. Falls insbesondere keine Graphitteile im Reaktor sind, ist auch Wasserstoff für den zweiten Gasstrom geeignet.

Die Wachstumstemperatur am Substrat wird vorzugsweise zwischen etwa 800° C und etwa 2500° C eingestellt.

In einer besonders vorteilhaften Ausführungsform wird einkristallines Siliciumcarbid hergestellt, das insbesondere für Halbleiterbauelemente eingesetzt werden kann.

Zur weiteren Erläuterung der Erfindung wird auf die Zeichnungen Bezug genommen.
- FIG 1: zeigt eine Vorrichtung zum Herstellen von Siliciumcarbid in einem Längsschnitt.
- In FIG 2: ist ein Querschnitt durch die Vorrichtung der FIG 1 dargestellt.
- FIG 3: zeigt Mittel zum Erzeugen zweier Gasströme als Teil einer Vorrichtung zum Herstellen von Siliciumcarbid.
- Die FIG 4 und 5: veranschaulichen zwei weitere Ausführungsbeispiele einer Vorrichtung zum Herstellen von Siliciumcarbid jeweils im Längsschnitt.

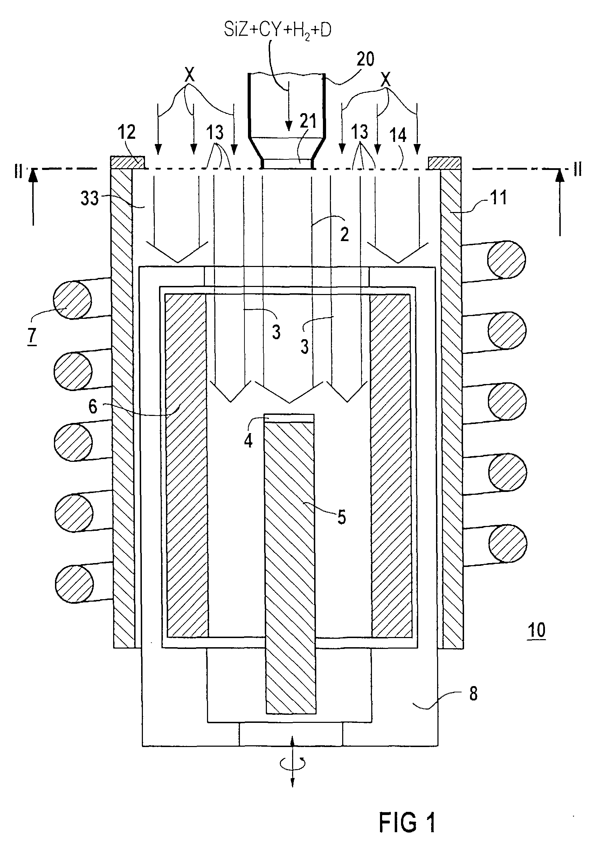

Die Vorrichtung gemäß FIG 1 enthält einen Reaktor 10 mit einer Außenwand 11, die insbesondere hohlzylindrisch (rohrförmig) ausgebildet sein kann und vorzugsweise gekühlt wird, beispielsweise mit einer Wasserkühlung. Die Außenwand 11 des Reaktors 10 kann insbesondere aus Quarzglas bestehen. Auf die Außenwand 11 ist an einer Stirnseite ein Deckel 12 aufgesetzt, beispielsweise angeflanscht. In dem von der Außenwand 11 umschlossenen Innenraum 33 des Reaktors 10 ist ein Suszeptor 6 angeordnet, der insbesondere hohlzylindrisch ausgebildet sein kann und durch ein von einer Hochfrequenzspule 7 erzeugtes Hochfrequenzfeld beheizt wird (Induktionsheizung). Ein bevorzugtes Material für den Suszeptor 6 ist Graphit. Der Suszeptor 6 ist vorzugsweise durch eine Wärmeisolierung 8, die beispielsweise aus einem Graphitschaum gebildet sein kann, thermisch von der Außenwand 11 isoliert. Im Inneren des Suszeptors 6 ist ein Substrathalter 5 zum Tragen eines Substrats 4 angeordnet. Der Substrathalter 5 besteht beispielsweise aus Graphit. Als Substrat 4 kann ein für einen CVD-Prozeß von SiC geeignetes Substrat verwendet werden, beispielsweise ein Silicium-Substrat (bei Temperaturen bis etwa 1400°C), ein Tantalcarbid (TaC)-Substrat oder ein SiC-Substrat.

Durch den Deckel 12 des Reaktors 10 ist in einem zentralen Bereich eine Düse 20 geführt mit einer in den Innenraum 33 des Reaktors 10 mündenden und dem Substrat 4 zugewandten Auslaßöffnung 21. Die Abmessungen der Auslaßöffnung 21 der Düse 20 sind vorzugsweise den Abmessungen des Substrats 4 in wenigstens einer Richtung angepaßt. Der Abstand zwischen der Auslaßöffnung 21 der Düse 20 und dem Substrat 4 beträgt im allgemeinen zwischen etwa 2 cm und etwa 50 cm. Der Düse 20 werden für einen CVD-Prozeß zum Herstellen von Siliciumcarbid (SiC), insbesondere zum Herstellen von einkristallinem Siliciumcarbid, geeignete Prozeßgase zugeführt. Diese Prozeßgase umfassen wenigstens ein, mit SiZ bezeichnetes Arbeitsgas (precursor, source) zum Zuführen von Silicium (Si), wenigstens ein, mit CY bezeichnetes Arbeitsgas zum Zuführen von Kohlenstoff (C), wenigstens ein Trägergas (carrier gas), im allgemeinen Wasserstoff H₂, und gegebenenfalls auch ein Dotiergas D für eine gewünschte Dotierung des SiC. Das Gasgemisch aus diesen Prozeßgasen strömt als ein erster Gasstrom 2 durch die Auslaßöffnung 21 der Düse 20 auf das Substrat 4 zu in den beheizten Innenraum des Suszeptors 6. Die Strömungsgeschwindigkeit der Prozeßgase ist dabei beim Austritt aus der Düse 20 größer als beim Einlaß in die Düse 20. Beim Auftreffen des ersten Gasstromes 2 auf das beheizte Substrat 4 scheidet sich durch chemische Reaktionen aus den Arbeitsgasen unter Mitwirkung des Wasserstoff-Trägergases (CVD = Chemical Vapour Deposition = chemische Gasphasenabscheidung) Siliciumcarbid ab. Die Struktur des abgeschiedenen Siliciumcarbids ist insbesondere abhängig vom Material des Substrats 4 und von den an der Wachstumsfläche herrschenden Wachstumstemperaturen. Bei höheren Wachstumstemperaturen von im allgemeinen über etwa 800° C ist das aufwachsende SiC einkristallin, bei darunterliegenden Wachstumstemperaturen dagegen polykristallin oder amorph. Die Wachstumstemperaturen können durch die Energie des Hochfrequenzfeldes der Hochfrequenzspule 7 eingestellt werden. Der erste Gasstrom 2 kann unter einem frei vorgebbaren Winkel zwischen 0° und 90° auf das Substrat 4 auftreffen, vorzugsweise unter etwa 90°.

Der Substrathalter 5 kann vorzugsweise entlang einer Längsachse nach oben und unten verschoben werden. Dadurch kann das Substrat 4 oder die Wachstumsfläche am aufwachsenden SiC an einen gewünschten Ort im Temperaturfeld im Innern des Suszeptors 6 gebracht werden. In einer besonders vorteilhaften Ausführungsform ist der Substrathalter 5 um seine Längsachse drehbar. Durch kontinuierliches Drehen des Substrathalters 5 und damit des Substrats 4 während des Prozesses kann die Homogenität des aufwachsenden SiC deutlich erhöht werden. Typische Drehraten liegen zwischen etwa 5 Umdrehungen pro Minute (Upm) und etwa 1000 Upm. Diese Ausführungsform mit rotierendem Substrathalter 5 ist besonders günstig in Verbindung mit einer schlitzförmigen Auslaßöffnung 21 der Düse 20, da die Asymmetrie des ersten Gasstromes 2 durch die Rotation des Substrats 4 ausgeglichen wird.

Neben dem ersten Gasstrom 2 wird ein zweiter Gasstrom 3 erzeugt, der den ersten Gasstrom 2 seitlich umgibt. Die beiden Gasströme 2 und 3 strömen somit im wesentlichen parallel zueinander. Durch den zweiten Gasstrom 3 wird die Divergenz des ersten Gasstroms 2 zwischen der Auslaßöffnung 21 und dem Substrat 4 deutlich reduziert. Dadurch erreicht man eine um einen Faktor von bis zu 10 höhere Ausbeute der verwendeten Prozeßgase, insbesondere der Arbeitsgase SiZ und CY. Über den zweiten Gasstrom 3 wird vorzugsweise auch der Gesamtdruck im Reaktor 10 gesteuert. In der dargestellten Ausführungsform gemäß FIG 1 bietet der zweite Gasstrom 3 den zusätzlichen Vorteil, daß der Wasserstoff im ersten Gasstrom 2 im wesentlichen von den Graphitteilen im Reaktor 10, insbesondere dem Suszeptor 6, ferngehalten wird. Dadurch wird eine chemische Zersetzung (Korrosion) des Suszeptors 6 verhindert, und das eingestellte Verhältnis der Arbeitsgase im ersten Gasstrom 2 kann besser eingehalten werden. Der zweite Gasstrom 3 besteht aus einem Gas oder einem Gasgemisch, das in den Wachstumsprozeß am Substrat 4 chemisch nicht eingreift. Besonders vorteilhaft für den zweiten Gasstrom 3 ist ein Gas oder Gasgemisch mit einer geringeren Viskosität als das Gasgemisch des ersten Gasstromes 2. Besonders vorteilhaft für den zweiten Gasstrom 3 ist ein Edelgas wie beispielsweise Helium (He) oder Argon (Ar) oder ein Gemisch aus Edelgasen.

Zum Erzeugen des zweiten Gasstroms 3 sind in dem Deckel 12 des Reaktors 10 mehrere Einlaßöffnungen 13 vorgesehen, durch die ein mit X bezeichnetes Gas oder Gasgemisch in den von der Außenwand 11 umgrenzten Innenraum 33 des Reaktors 10 einströmen kann. Diese Einlaßöffnungen 13 sind um die Auslaßöffnung 21 der Düse 20 angeordnet in einer vorzugsweise konzentrischen Anordnung. Die Einlaßöffnungen 13 im Deckel 12 sind vorzugsweise so ausgebildet, daß aus dem zugeführten Gas X ein weitgehend homogener zweiter Gasstrom 3 entsteht. Besonders vorteilhaft ist die Verwendung eines Diffusors 14, der zum Erzeugen einer homogenen Gasströmung vorzugsweise mit einem Metallgeflecht gebildet ist mit einer Maschenweite von zwischen etwa 100 µm und etwa 500 µm. Solche Diffusoren 14 können käuflich erworben werden. Der Diffusor 14 ist an seinen Rändern mit entsprechenden Befestigungsmitteln eingespannt und bildet einen Teil des Deckels 12. In der dargestellten Ausführungsform gemäß FIG 1 sind die Einlaßöffnungen 13 bzw. die Maschen des Diffusors 14 im wesentlichen auf gleicher Höhe, d.h. im wesentlichen in einer Ebene, mit der Auslaßöffnung 21 der Düse 20 angeordnet. Die Auslaßöffnung 21 der Düse 20 kann aber auch in Strömungsrichtung des ersten Gasstromes 2 in den Innenraum 33 versetzt angeordnet sein.

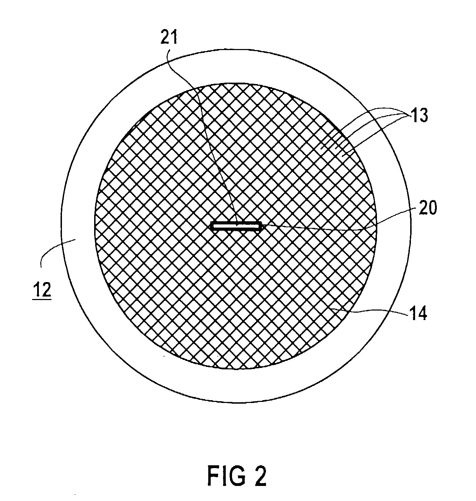

Die FIG 2 zeigt einen in der FIG 1 mit II bezeichneten Schnitt durch den Deckel 12 und die Düse 20 der Vorrichtung gemäß FIG 1. Der Diffusor 14 mit den Einlaßöffnungen 13 ist als Metallgeflecht zwischen die Düse 20 und einen nicht extra bezeichneten Rand des Deckels 12 eingespannt. Das Netz (Geflecht) des Diffusors 14 umgibt die Auslaßöffnung 21 der Düse 20 in einem möglichst nahen Abstand. Die Auslaßöffnung 21 der Düse 20 ist in der in Figur 2 dargestellten Ausführungsform schlitzförmig gebildet, wobei die Längsabmessung des Schlitzes dem Durchmesser des Substrats 4 angepaßt ist.

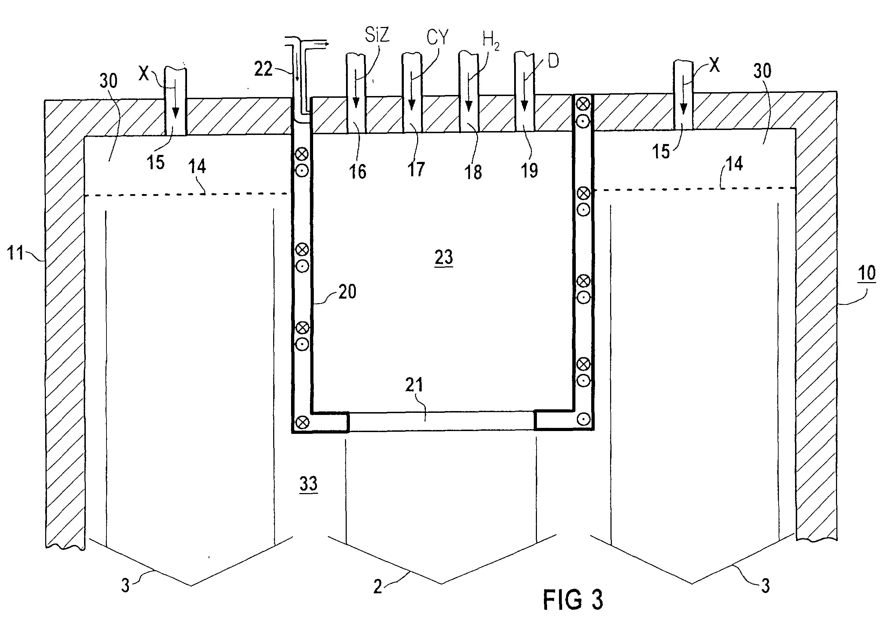

Die FIG 3 zeigt eine vergrößerte Ansicht des Gaseinlaßbereichs im oberen Teil des Reaktors 10 im Querschnitt. In den von der Außenwand 11 umgebenen Innenraum 33 des Reaktors 10 ragt die Düse 20. Die Düse 20 wird wieder von dem Diffusor 14 umgeben. Zwischen der Außenwand 11, dem Diffusor 14 und der Düse 20 ist ein vom restlichen Innenraum 33 des Reaktors 10 abgetrennter Gasvorraum 30 gebildet. In diesen Gasvorraum 30 wird über eine oder mehrere Einlaßöffnungen 15 das Gas X für den zweiten Gasstrom 3 eingeleitet und durch den Diffusor 14 in den Innenraum 33 des Reaktors 10 als zweiter Gasstrom 3 geführt. In den Düseninnenraum 23 der Düse 20 werden über eine Einlaßöffnung 16 das Arbeitsgas SiZ, über eine weitere Einlaßöffnung 17 das Arbeitsgas CY, über eine dritte Einlaßöffnung 18 das Trägergas Wasserstoff und über eine vierte Einlaßöffnung 19 ein Dotiergas D eingeleitet. Das Gasgemisch aus diesen Prozeßgasen strömt durch die Auslaßöffnung 21 der Düse 20 als erster Gasstrom 2 in den Innenraum 33 des Reaktors 10. Die Auslaßöffnung 21 der Düse 20 ist in dieser Ausführungsform gegenüber dem Diffusor 14 in den Innenraum 33 des Reaktors 10 versetzt und damit näher am nicht dargestellten Substrat 4 angeordnet als der Diffusor 14. Der zweite Gasstrom 3 strömt zwischen der Außenwand 11 und der Düse 20 bis zur Höhe der Auslaßöffnung 21 der Düse 20 und dann im wesentlichen parallel zum Gasstrom 2. Da die Düse 20 in dieser Ausführungsform näher an dem beheizten Bereich des Reaktors 10 angeordnet ist, ist vorzugsweise eine Kühlung 22 für die Düse 20 vorgesehen, beispielsweise eine Flüssigkeitskühlung mit einer Zuleitung und einer parallel zur Zuleitung geführten Ableitung. Solche Flüssigkeitskühlungen 22, insbesondere Wasserkühlungen, sind dem Fachmann an sich bekannt. Ein Vorteil der in den Innenraum 33 hineinragenden Düse 20 ist die geringe Vermischung der Gasströme 2 und 3 wegen des kurzen gemeinsamen Weges.

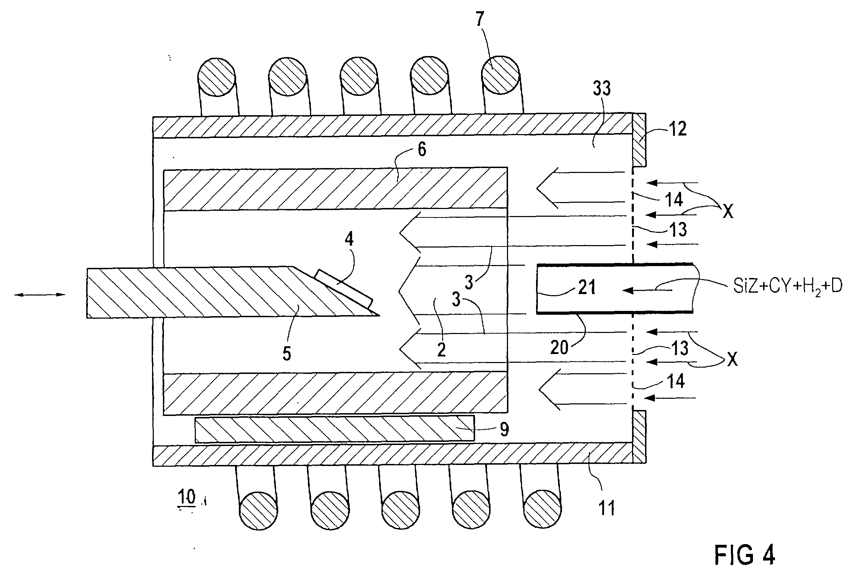

Im weiteren Ausführungsbeispiel der FIG 4 ist eine Vorrichtung dargestellt mit einem gegenüber dem Ausführungsbeispiel der FIG 1 um 90° gedrehten Reaktor 10 (horizontaler Reaktor).

In dieser Ausführungsform gemäß FIG 4 sind der erste Gasstrom 2 und der zweite Gasstrom 3 im wesentlichen horizontal gerichtet. Das Substrat 4 ist auf einer Schrägfläche des Substrathalters 5 angeordnet. Der erste Gasstrom 2 trifft somit unter einem Winkel auf das Substrat 4 und strömt dann über das Substrat 4 hinweg, im Gegensatz zum Ausführungsbeispiel gemäß FIG 1, bei dem der erste Gasstrom 2 im wesentlichen senkrecht auf das Substrat 4 auftrifft. Das Substrat 4 kann aber auch wieder senkrecht zum ersten Gasstrom 2 angeordnet sein wie in FIG 1. Der Suszeptor 6 ist auf einer Unterlage 9 angeordnet. Ein weiterer Unterschied zur Ausführungsform gemäß FIG 1 besteht darin, daß die Düse 20 ähnlich wie bei der Ausführungsform gemäß FIG 3 in den Innenraum 33 des Reaktors 10 hineinragt. Dadurch erreicht man einen kurzen Abstand zwischen dem Substrat 4 und der Auslaßöffnung 21 der Düse 20. Die Düse 20 ist in dieser Ausführungsform vorzugsweise wieder gekühlt. Auch kann der Substrathalter 5 wieder längs seiner Längsachse verschoben werden.

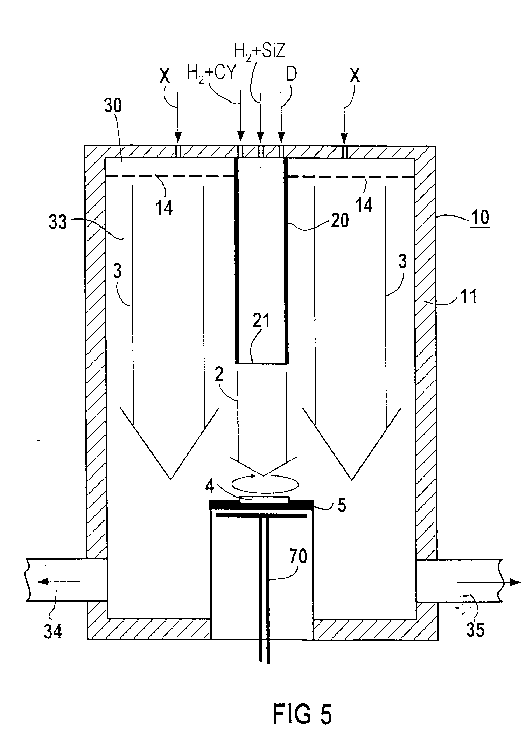

In FIG 5 ist eine weitere Ausführungsform der Vorrichtung zum Herstellen von Siliciumcarbid dargestellt. In dieser Ausführungsform wird der Substrathalter 5 direkt beheizt. Dazu ist unter dem Substrathalter 5 eine Hochfrequenzspule 70 angeordnet, vorzugsweise eine Flachspule (Pancake-Spule). Diese Ausführungsform der Heizmittel zum Beheizen des Substrats 4 hat den Vorteil, daß im Transportbereich für den ersten Gasstrom 2 und den zweiten Gasstrom 3 keine Graphitteile im Innenraum 33 des Reaktors 10 angeordnet sind. Als Gas X für den zweiten Gasstrom 3 kann deshalb sogar Wasserstoff verwendet werden. Für die Außenwand 11 des Reaktors 10 kann beispielsweise auch ein Edelstahl verwendet werden. Die Außenwand 11 wird vorzugsweise gekühlt. Es ist wieder eine in den Innenraum 33 des Rektors 10 hineinragende Düse 20 vorgesehen, die vorzugsweise wieder gekühlt wird. Ferner sind auch Auslaßöffnungen 34 und 35 dargestellt, über die mit Hilfe von nicht dargestellten Pumpen die überschüssigen Gase aus dem Innenraum 33 des Reaktors 10 abgepumpt werden. Solche Auslaßöffnungen sind auch bei den anderen Ausführungsformen der Vorrichtung vorgesehen. Der Substrathalter 5 mit dem Substrat 4 ist vorzugsweise wieder um eine Längsachse drehbar.

Der Substrathalter 5 kann auch direkt beheizt werden, indem er von einem elektrischen Strom durchflossen wird (Widerstandsheizung). Zum Erzeugen des ersten Gasstromes 2 kann in allen Ausführungsformen auch nur eine einfache Einlaßöffnung anstelle einer Düse vorgesehen sein, durch die die Prozeßgase und die Trägergase sowie gegebenenfalls Dotiergase in den Reaktor eingelassen werden.

Die Strömungsgeschwindigkeit des auf das Substrat 4 gerichteten, ersten Gasstromes 2 wird in allen Ausführungsformen im allgemeinen möglichst groß eingestellt und liegt zwischen 10 m/min und 300 m/min, vorzugsweise zwischen 20 m/min und 60 m/min. Dies kann durch entsprechende Wahl der Düse 20 erreicht werden.

Die Strömungsgeschwindigkeit des zweiten Gasstromes 3 wird vorzugsweise niedrig gehalten, um den Verbrauch an Gasen zu begrenzen. In einer vorteilhaften Ausführungsform wird die Strömungsgeschwindigkeit des ersten Gasstromes 2 größer eingestellt als die Strömungsgeschwindigkeit des zweiten Gasstromes 3, im allgemeinen zwischen etwa dem 3fachen und etwa dem 30fachen.

Als Prozeßgase im ersten Gasstrom 2 können in allen Ausführungsformen prinzipiell alle bekannten Arbeitsgase zum Zuführen von Silicium und/oder Kohlenstoff und Trägergase sowie gegebenenfalls Dotiergase verwendet werden. Beispielsweise können als Arbeitsgas SiZ zum Zuführen von Silicium Silan, als Arbeitsgas CY zum Zuführen von Kohlenstoff Propan und als Trägergas Wasserstoff (H₂) verwendet werden. Die Konzentration von Silan beträgt vorzugsweise zwischen etwa 0,1 % und etwa 3 % in dem ersten Gasstrom 2. Die Konzentration von Propan wird im allgemeinen etwa um einen Faktor 3 niedriger eingestellt als die Konzentration des Silans. Prinzipiell können alle bekannten Gaskonzentrationen und Gasverhältnisse eingestellt werden.

Der Strömungsquerschnitt des ersten Gasstromes 2 richtet sich nach den Abmessungen des Substrates 4. Der Strömungsquerschnitt des äußeren zweiten Gasstromes 3 ist im allgemeinen durch die Abmessung des für den CVD-Prozeß vorgesehenen Reaktors 10 vorgegeben und kann prinzipiell beliebig gewählt werden.

Der Gasgesamtdruck im Reaktor 10 wird im allgemeinen zwischen 0,1 und 1 bar eingestellt, vorzugsweise zwischen 0,2 und 0,5 bar.

Die Wachstumstemperaturen am Substrat 4 werden im allgemeinen zwischen 800° C und 2500° C und vorzugsweise zwischen 1200° C und 2400° C eingestellt zum Herstellen von einkristallinem SiC.

Ein besonderer Vorteil des Verfahrens gemäß der Erfindung besteht darin, daß SiC-Kristalle großer Länge und mit großem Durchmesser gezüchtet werden können, da auch bei Graphitwänden und Graphitteilen im Reaktor keine Abscheidungs- und/oder Auflösungserscheinungen auftreten.

## Patentansprüche

1. Verfahren zum Herstellen von Siliciumcarbid, bei dem
a) ein erster Gasstrom (2), der wenigstens ein Arbeitsgas zum Zuführen von Silicium (Si) und Kohlenstoff (C) und wenigstens ein Trägergas enthält, auf ein Substrat (4) gerichtet wird und aus diesem ersten Gasstrom (2) auf dem Substrat (4) durch chemisches Abscheiden aus der Gasphase (CVD) Siliciumcarbid abgeschieden wird,
b) ein zweiter Gasstrom (3) erzeugt wird, der den ersten Gasstrom (2) parallel zu dessen Strömungsrichtung vollständig umschließt und der in den Abscheidevorgang am Substrat (4) chemisch nicht eingreift,
c) eine Strömungsgeschwindigkeit des ersten Gasstromes (2) zwischen 10 m/min und 300 m/min eingestellt wird.

2. Verfahren nach Anspruch 1, bei dem die Strömungsgeschwindigkeit des ersten Gasstromes (2) zwischen 20 m/min und 60 m/min eingestellt wird.

3. Verfahren nach Anspruch 1 oder Anspruch 2, bei dem die Strömungsgeschwindigkeit des ersten Gasstromes (2) größer eingestellt wird als die Strömungsgeschwindigkeit des zweiten Gasstromes (3).

4. Verfahren nach einem der vorhergehenden Ansprüche, bei dem für den zweiten Gasstrom (3) ein Gas oder Gasgemisch mit einer geringeren Viskosität als der erste Gasstrom (2) verwendet wird.

5. Verfahren nach einem der vorhergehenden Ansprüche, bei dem für den zweiten Gasstrom (3) ein Edelgas oder ein Edelgasgemisch verwendet wird.

6. Verfahren nach einem der vorhergehenden Ansprüche, bei dem die Wachstumstemperatur am Substrat (4) zwischen etwa 800 °C und etwa 2500 °C eingestellt wird.

7. Verfahren nach einem der vorhergehenden Ansprüche zum Herstellen von einkristallinem Siliciumcarbid.

## Claims

1. Process for producing silicon carbide, in which
a) a first gas stream (2), which contains at least one working gas for supplying silicon (Si) and carbon (C) and at least one carrier gas, is directed onto a substrate (4) and silicon carbide is deposited out of this first gas stream (2) on the substrate (4) by chemical vapour deposition (CVD),
b) a second gas stream (3) is generated, which completely encloses the first gas stream (2) parallel to its direction of flow and which is chemically inactive in the operation of deposition on the substrate (4),
c) a flow velocity of the first gas stream (2) of between 10 m/min and 300 m/min is set.

2. Process according to Claim 1, in which the flow velocity of the first gas stream (2) is set at between 20 m/min and 60 m/min.

3. Process according to Claim 1 or Claim 2, in which the flow velocity of the first gas stream (2) is set at a higher level than the flow velocity of the second gas stream (3) .

4. Process according to one of the preceding claims, in which a gas or a gas mixture with a lower viscosity than the first gas stream (2) is used for the second gas stream (3).

5. Process according to one of the preceding claims, in which an inert gas or an inert-gas mixture is used for the second gas stream (3).

6. Process according to one of the preceding claims, in which the growth temperature on the substrate (4) is set at between approximately 800°C and approximately 2500°C.

7. Process according to one of the preceding claims for producing single-crystalline silicon carbide.

## Revendications

1. Procédé de préparation de carbure de silicium, dans lequel
a) un premier courant (2) gazeux qui comporte au moins un gaz de travail pour apporter du silicium (Si) et du carbone (C) et au moins un gaz inerte est dirigé sur un substrat (4) et il est déposé à partir de ce premier courant (2) gazeux sur le substrat (4) par dépôt chimique en phase gazeuse (CVD) du carbure de silicium,
b) il est produit un deuxième courant (3) gazeux qui entoure entièrement le premier courant (2) gazeux parallèlement à sa direction d'écoulement et qui n'intervient pas chimiquement dans le processus de dépôt sur le substrat (4),
c) il est établi une vitesse d'écoulement du premier courant (2) gazeux comprise entre 10m/min. et 300 m/min.

2. Procédé suivant la revendication 1, dans lequel la vitesse d'écoulement du premier courant (2) gazeux est réglée entre 20 m/min. et 60 m/min.

3. Procédé suivant la revendication 1 ou la revendication 2, dans lequel on règle la vitesse d'écoulement du premier courant (2) gazeux à une valeur plus grande que la vitesse d'écoulement du deuxième courant (3) gazeux.

4. Procédé suivant l'une des revendications précédentes, dans lequel on utilise pour le deuxième courant (3) gazeux un gaz ou un mélange gazeux ayant une viscosité plus petite que celle du premier courant (2) gazeux.

5. Procédé suivant l'une des revendications précédentes, dans lequel on utilise pour le deuxième courant (3) gazeux un gaz rare ou un mélange de gaz rares.

6. Procédé suivant l'une des revendications précédentes, dans lequel on règle la température de croissance sur le substrat (4) entre 800°C environ et 2500°C environ.

7. Procédé suivant l'une des revendications précédentes pour la préparation de carbure de silicium monocristallin.
